# FASCICULE DE BREVET EUROPEEN

(11) **EP 3 275 024 B1**
(45) Date de publication et mention de la délivrance du brevet: **17.02.2021**
(21) Numéro de dépôt: 16718404.3
(22) Date de dépôt: 24.03.2016
(51) Int. Cl.: H01L 41/00, H01L 41/45, H01L 41/18, G01H 11/08

(54) **CAPTEUR PIÉZOÉLECTRIQUE ET INSTRUMENT COMPORTANT UN TEL CAPTEUR**
EIN PIEZOELEKTRISCHER SENSOR UND EIN INSTRUMENT MIT EINEM SOLCHEN SENSOR
PIEZOELECTRIC SENSOR AND INSTRUMENT WITH SUCH A SENSOR

(30) Priorité: 25.03.2015 FR 1552487
(43) Date de publication de la demande: 31.01.2018
(73) Titulaire: Université de Lorraine, 54052 Nancy Cedex (FR)
(72) Inventeur: ROUXEL, Didier, 54550 Pont-Saint-Vincent (FR); VINCENT, Brice, 54510 Tomblaine (FR); BADIE, Laurent, 54500 Vandoeuvre-les-Nancy (FR)
(74) Mandataire: Novagraaf Technologies
(86) Numéro de dépôt international: PCT/FR2016/050650
(87) Numéro de publication internationale: WO 2016/151252

(56) Documents cités:
- EP-A1- 2 545 960
- EP-A2- 1 519 165
- WO-A1-2014/185530
- US-A1- 2011 166 459
- US-A1- 2012 193 568
- US-A1- 2014 180 117

## Description

### Domaine technique

La présente invention se rapporte à un capteur piézoélectrique pour la mesure de vibrations de faible amplitude et d'objets légers. Elle concerne également un instrument pour la mesure de vibrations, en particulier pour un usage médical.

### Etat de la technique

Le domaine médical demande divers capteurs en particulier acoustiques dans des applications relatives à l'audition et à sa correction. Ces capteurs doivent être compacts et sensibles à une gamme de fréquences dans le domaine audible.

On connaît par le document WO 2012/018400 A1 un capteur sonore destiné à capter le son ambiant pour le transmettre à un implant dans l'oreille. Le capteur est destiné à être implanté sous la peau. Le capteur utilise une membrane en PVDF pour ses propriétés piézoélectriques afin que les ondes sonores soient transformées en signaux électriques. Dans le cas d'implants cochléaires, les signaux électriques sont envoyés par des conducteurs au nerf auditif. Dans certaines configurations présentées, la membrane est fixée sur un corps annulaire de manière à s'étendre au-dessus d'une cavité centrale du corps. De plus, la couche sensible piézoélectrique peut être recouverte par une couche en élastomère de silicone, par exemple en forme de lentille.

Le document US 2011/0137109 A1 montre un capteur auditif destiné à être implanté dans l'oreille moyenne à l'interface entre deux osselets, avec une membrane en contact avec le premier des osselets, le corps du capteur ou une autre membrane prenant appui sur l'autre osselet. Le
comporte également un élément sensible piézoélectrique connecté à la membrane pour générer les signaux électriques.

Un tel capteur comporte une interface entre la membrane et l'élément sensible, laquelle induit des réductions de transmission en fonction des fréquences. Il nécessite également des éléments de ressort pour maintenir l'élément sensible en contact avec la membrane, ce qui rend sa fabrication complexe.

Les documents US 2014/180117 A1, US 2011/166459 A1, EP 1519 165A2, WO2014185530, US2012193568; EP2545960A1 divulguent également des capteurs piezzoelectriques permettant de mesurer les vibrations, néanmoins leur mesures ne sont pas satisfaisantes.

La présente invention vise à fournir un capteur piézoélectrique pour la mesure de vibrations ou de petits déplacements adapté aux fréquences sonores qui ait une bonne sensibilité et qui soit simple à réaliser. Elle concerne également un instrument pour la mesure de vibrations, en particulier pour un usage médical.

### Description de l'invention

Avec ces objectifs en vue, l'invention a pour objet un capteur piézoélectrique selon l'objet de la revendication indépendante de dispositif.

Dans un tel capteur, la membrane est la partie qui capte le mouvement mécanique et celle qui convertit ce mouvement en signal électrique. En outre, la couche sensible est située directement à l'extérieur pour venir en contact avec la source de mouvements ou de vibrations. On s'affranchit ainsi d'une interface entre une membrane et un élément sensible. Par ailleurs, l'insertion de nanomatériaux dans la matrice en polymère permet d'adapter l'impédance acoustique de la couche sensible en fonction de l'application souhaitée. Il a été établi que l'insertion des nanomatériaux, dans certaines limites, n'affecte pas les propriétés piézoélectriques de la souche sensible. La proportion de nanomatériaux peut atteindre par exemple 20% en masse.

La présence de nanomatériaux dans la couche sensible est centrale car elle permet d'adapter l'impédance acoustique de la couche sensible en fonction de l'application souhaitée. Ceci permet d'optimiser le transfert d'énergie acoustique de l'objet sondé vers la membrane. La variation des constantes élastiques peut atteindre plus de 30%, ce qui entraine une variation favorable du coefficient de transfert de puissance de plus de 100%, et ce, suivant le désaccord d'impédance acoustique entre l'objet sondé et la matrice du nanocomposite.

Selon certaines caractéristiques, la couche de support a une épaisseur comprise entre 5 et 150 µm, de préférence 25 µm.

Selon une autre caractéristique, la membrane est fixée sur le corps par collage.

De manière particulière, la membrane est fixée sur le corps par la couche de support.

De manière complémentaire, une première couche conductrice est interposée entre la couche de support et la couche sensible. La première couche conductrice permet de collecter les charges électriques créées par la couche sensible.

De manière complémentaire, une deuxième couche conductrice est déposée sur une partie au moins d'une surface libre de la couche sensible. La deuxième couche conductrice permet de collecter les charges électriques créées par la couche sensible. Les deux couches conductrices permettent d'acquérir le signal électrique.

L'invention a aussi pour objet un instrument caractérisé en ce qu'il comporte un capteur selon l'une des revendications précédentes et une tige de transmission dont une première extrémité est destinée à être appliquée contre une masse susceptible d'entrer en vibration et une deuxième extrémité en appui sur la membrane du capteur.

Ainsi, la combinaison de la membrane nanocomposite avec la tige de transmission permet de mesurer des vibrations de tres faible amplitudes sur des élements de faible dimensions (inférieur à 1 mm).

Un tel instrument est destiné à mesurer les vibrations de la masse. Il est particulièrement destiné à réaliser un contrôle dans le cadre d'une opération chirurgicale de l'oreille, pour vérifier que les ondes acoustiques sont transmises le long de la chaine de transmission auditive. Par exemple, la tige de transmission peut être appliquée contre l'un des osselets de l'oreille moyenne afin de vérifier que celui-ci reçoit les ondes acoustiques captées par le tympan. Les ondes acoustiques sont transmises au capteur par la tige de transmission. Le capteur peut être adapté à la gamme de fréquence d'onde acoustique désirée par le choix de l'impédance acoustique de la couche sensible.

De manière complémentaire, l'instrument comporte une tête dans laquelle le capteur est logé, la tige étant reliée par des moyens élastiques à la tête. Ainsi, la tige est découplée de la tête et peut transmettre ses ondes au capteur sans atténuation. De plus, la tige de transmission peut être mise en appui en permanence contre la couche sensible du capteur afin d'assurer un bon couplage.

Selon une caractéristique constructive, la deuxième extrémité de la tige comporte une surface bombée pour être en appui sur la membrane.

### Brève description des figures

L'invention sera mieux comprise et d'autres particularités et avantages apparaîtront à la lecture de la description qui va suivre, la description faisant référence aux dessins annexés parmi lesquels :
- la figure 1 représente est une vue d'un instrument conforme à un mode de réalisation de l'invention ;
- la figure 2 est une vue en coupe selon la ligne II-II de la figure 1 ;
- la figure 3 est un schéma électronique de l'instrument de la figure 1 ;
- la figure 4 est une vue du détail IV de la figure 2 ;
- la figure 5 est une vue du détail V de la figure 4 ;
- la figure 6 est une vue d'un capteur incorporé à l'instrument de la figure 1 ;
- la figure 7 est un diagramme montrant un exemple de mesure faite par un capteur conforme à l'invention soumis à des vibrations à différentes fréquences ;
- La figure 8 montre un exemple de tension mesurée en fonction du temps en sortie d'un capteur conforme à l'invention ;
- La figure 9 montre la tension mesurée en sortie d'un capteur conforme à l'invention en fonction de l'amplitude de la vibration mécanique transmise à la membrane.

### DESCRIPTION DETAILLÉE

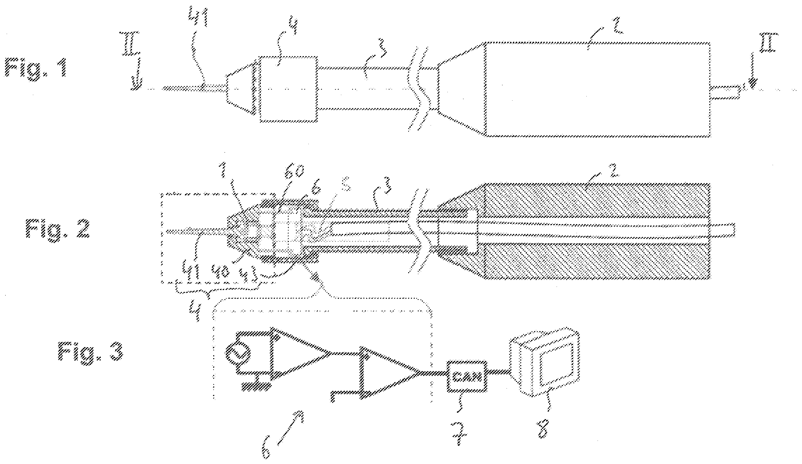

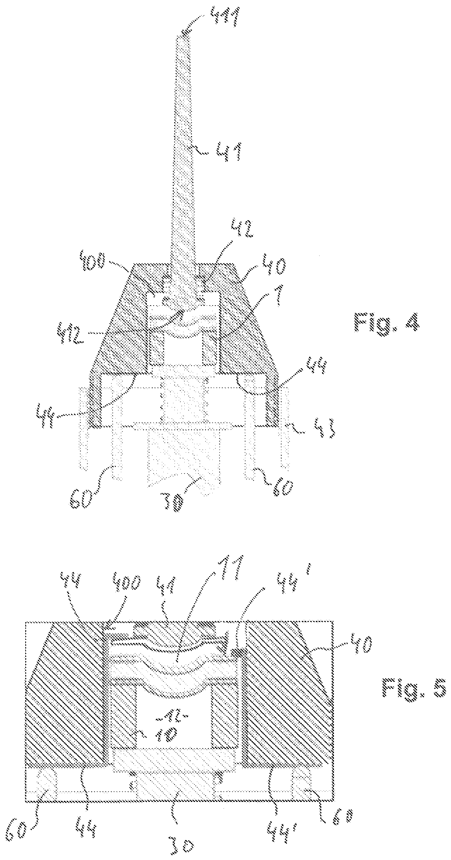

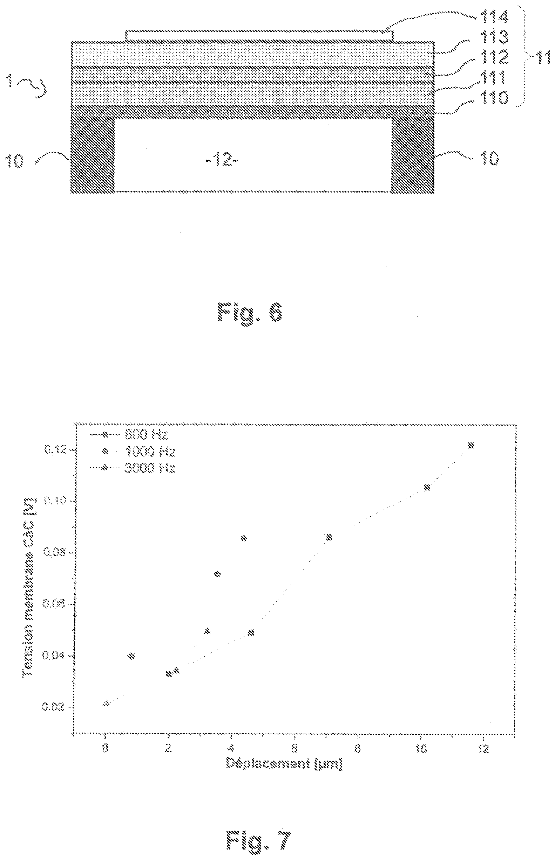

Un instrument conforme à un mode de réalisation de l'invention est représenté sur les figures 1 à 5. L'instrument comporte un capteur 1 conforme également à l'invention et représenté en particulier sur la figure 6.

L'instrument comporte un manche 2 prolongé d'un tube 3 au bout duquel se trouve une tête 4. La tête 4 incorpore le capteur 1 et une tige 41 de transmission dont une première extrémité 411 est destinée à être appliquée contre un objet ou une masse susceptible d'entrer en vibration. La tête 4 comporte une douille 40 qui s'assemble avec le tube 3, par exemple avec une bague filetée 43. La douille 40 supporte la tige 41 par l'intermédiaire de moyens élastiques 42. La douille 40 est par exemple en matière synthétique isolante électriquement.

L'instrument comporte des conducteurs électriques 5 qui traversent le manche 2 et le tube 3 et qui sont reliés à un circuit électronique 6 d'amplification. Le circuit électronique 6, tel que schématisé sur la figure 3, comporte des plots élastiques 60 qui viennent en contact avec des lames 44 conductrices déposées à l'intérieur de la douille 40, lesquelles sont reliées au capteur 1, d'une manière détaillée ci-après.

Le capteur 1 est logé à l'intérieur de la douille 40, guidé dans un alésage 400. Il comporte un corps 10 de forme annulaire et une membrane 11 fixée sur le corps 10 par sa périphérie et s'étendant au-dessus d'un évidement 12 au centre du corps 10. La membrane 11 est mise en appui contre une deuxième extrémité 412 de la tige 41. La deuxième extrémité 412 de la tige 41 comporte une surface bombée pour être en appui sur la membrane 11 sur une surface limitée à l'opposé de l'évidement 12. Il est préférable que la surface de contact entre la membrane 11 et la tige 41 soit une faible proportion de la section de l'évidement 12 afin de laisser la possibilité de flexion à la membrane 11. Le capteur 1 est mis en appui de manière élastique contre la tige 41 par un poussoir 30 logé de manière coulissante dans le tube 3.

La membrane 11 comporte successivement une couche de support 111 en matière synthétique, une première couche conductrice 112 déposée sur la couche de support 111, une couche sensible 113 en matière synthétique piézoélectrique déposée sur la première couche conductrice 112 et comprenant un polymère et des nanomatériaux inorganiques, et une deuxième couche conductrice 114 déposée sur une partie d'une surface libre de la couche sensible 113. La membrane 11 est apte à se déformer ou à vibrer au-dessus de l'évidement 12.

La membrane 11 comporte au moins une encoche à sa périphérie de manière à laisser libre une partie de la première couche conductrice 112. L'une des lames 44' s'y insère pour établir un contact électrique sur la première couche conductrice 112. Au moins une autre lame 44 s'étend jusqu'à la deuxième couche conductrice 114 pour y établir un contact électrique.

Le corps 10 est par exemple un substrat de silicium obtenu par des techniques en usage en micro-électronique. L'évidement 12 est réalisé par exemple par lithographie optique et gravure ionique réactive profonde (DRIE). La gravure est stoppée environ 50 micromètres avant la surface supérieure du corps 10 pour garder celle-ci intacte afin de réaliser les étapes de fabrication suivantes. La membrane 11 est fixée par collage sur la face du corps 10 non évidée grâce à une couche de colle 110 étendue sur ladite face.

La fabrication de la membrane 11 est décrite ci-après. La couche de support 111 est découpée dans un film polymère laminé de 25 µm d'épaisseur en Polyimide (PI, Kapton®) ou PolyEtherEtherKetone (PEEK, Aptiv100®). Ces films ont de bonnes propriétés de maintien de forme. Le corps 10 et le film laminé sont exposés à un traitement plasma d'oxygène afin de modifier leurs états de surface pour les rendre hydrophiles et maximiser ainsi leur affinité chimique avec la colle 110. La face plane du corps 10 est recouverte de Poly Diméthyle Siloxane (PDMS, Sylgard® 184) assurant le rôle de la colle par la technique de l'épandage centrifuge pour déposer une épaisseur homogène. La couche de support 111 est ensuite appliquée à la surface de la colle 110 par une méthode de plaquage. L'ensemble est ensuite mis au four pendant 2h45 (temps de montée en température compris) à 100°C pour l'étape de polymérisation croisée assurant la rigidification de la colle 110 et son adhérence avec les deux matériaux.

Une fois l'échantillon revenu à température ambiante, la première couche conductrice 112 est réalisée par le dépôt d'aluminium en épaisseur de 100 nm par pulvérisation cathodique continue. La préparation du matériau sensible est effectuée par ajout de nanomatériaux d'alumine Al₂O₃ (Degussa AG, Francfort) dans du copolymère de fluorure de vinylidène et trifluoroéthylène (P(VDF-TrFE), Piézotech S.A.S.) en solution dans du méthyl-éthyl-cétone (MEK, Sigma Aldrich). Le mélange des deux matériaux se fait par ultrasonification avec la solution plongé dans un bain de glace pour éviter son réchauffement. Pour former la couche sensible 113, l'ensemble est ensuite recouvert par épandage centrifuge avec la solution de polymère et son nanomatériau d'une couche d'épaisseur de 100 nm à 15 µm. Le tout est ensuite mis au four directement à 138 °C pendant une heure suivie du temps nécessaire à la redescente à température ambiante. Un tel recuit permet de configurer la couche sensible 113 par recristallisation afin de lui conférer les propriétés piézoélectriques.

Cette couche sensible est ensuite soumise à une étape de polarisation, par une technique corona par exemple, afin d'orienter les propriétés piézoélectriques pour maximiser la réponse électrique de la couche aux déformations et vibrations.

L'électrode supérieure est ensuite déposée par évaporation d'une couche d'accroche en chrome de 10 nm et d'une épaisseur d'or de 70 nm par exemple. Cette électrode est ensuite structurée par microlithographie optique et gravure humide pour obtenir le motif désiré à la surface de la membrane 11. Afin de libérer la zone libre en vibration, le reste du corps 11 au niveau de l'évidement 12 est gravé par gravure réactive (RIE) ou gravure humide.

Lors de l'utilisation, un objet vibrant est mis en contact avec la première extrémité 411 de la tige 41. Les vibrations sont transmises par la tige 41 jusqu'à la membrane 11, qui assure une fonction de capteur 1 de déformation. La déformation de la membrane 11, par exemple le fléchissement et l'étirement sur les bords périphériques, est convertie par effet piézoélectrique en signal électrique qui est collecté par l'intermédiaire des deux couches conductrice 112, 114, par la création d'une différence de potentiel. Le signal électrique est transmis au circuit d'amplification 6 par l'intermédiaire des lames 44, 44' et des plots élastiques 60. Le signal fournit des informations sur la fréquence et l'amplitude des vibrations de l'objet sondé. Le signal amplifié est transmis à un appareil extérieur 7 qui en réalise son traitement et fournit des résultats par des moyens d'interface 8.

La figure 7 montre un digramme représentant la tension mesurée entre les couches conductrices en fonction de l'amplitude de sollicitation de la membrane et pour certaines fréquences de vibrations de la membrane sous l'excitation d'un pot vibrant pour une couche de P(VDF-TrFE) de 7 µm d'épaisseur et avec 5% de nanomatériaux d'Al₂O₃.

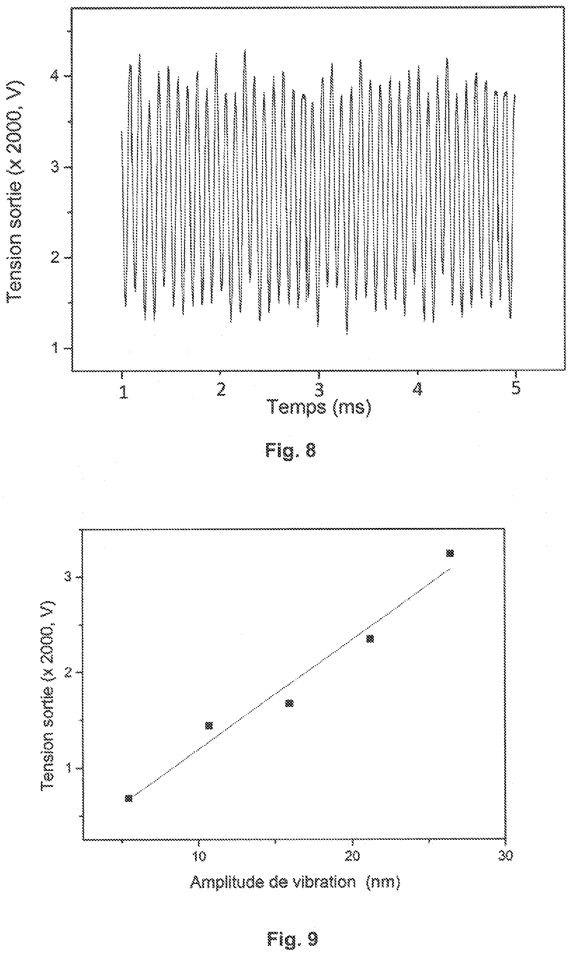

La figure 8 montre un exemple de tension mesurée en fonction du temps en sortie du capteur conforme à l'invention réalisé à partir d'une membrane nanocomposite piézoélectrique selon l'invention décrite ci-avant. L'amplitude d'excitation mécanique est de 20 nm.

La figure 9 montre l'évolution de la tension mesurée en sortie dudit capteur, en fonction de l'amplitude de la vibration mécanique transmise à la membrane.

Pour les deux figures, la frequence de vibration est de 1024Hz et la tension obtenue est représentée en volt après une amplification de x2000.

Comme le montrent ces deux figures 8 et 9, le capteur conforme à l'invention est capable de détecter des vibrations mécaniques de quelques nanomètres d'amplitude.

L'objet sondé est par exemple l'un des osselets de l'oreille moyenne lors d'une opération chirurgicale. Ceci permet au chirurgien de s'assurer que la chaîne des osselets conserve sa fonctionnalité au moins partiellement. Le chirurgien peut ainsi déterminer quelle partie reste fonctionnelle et mérite d'être conservée. L'instrument peut aussi être utilisé pour évaluer l'efficacité d'un implant après sa mise en place. Il peut aussi être utilisé pour déterminer une force d'appui sur un implant. Le geste chirurgical est ajusté en conséquence afin de garantir un résultat optimal après l'opération.

## Revendications

1. Instrument, **caractérisé en ce qu'**il comprend un capteur piézoélectrique comportant un corps (10) avec un évidement (12) central, une membrane (11) s'étendant par-dessus l'évidement (12), fixée sur le corps (10) par sa périphérie et comportant une couche de support (111) en polymère et une couche sensible (113) en matière polymère piézoélectrique, la membrane (11) étant apte à se déformer ou à vibrer, la couche sensible (113) étant dans un matériau comprenant un polymère chargé en nanomatériaux inorganiques d'alumine, le polymère de la couche sensible (113) étant choisi dans le groupe comprenant du polyfluorure de vinylidène (PVDF), du copolymère de fluorure de vinylidène et trifluoroéthylène P(VDF-TrFE) et du polyamide-11, la couche de support (111) étant dans un matériau choisi parmi le groupe comprenant du polyimide (PI) et du poly-éther-éther-cétone (PEEK), une première couche conductrice (112) en aluminium étant interposée entre la couche de support (111) et la couche sensible (113), une deuxième couche conductrice (114) étant déposée sur une partie d'une surface libre de la couche sensible (113),
l'instrument comportant en outre une tige (41) de transmission dont une première extrémité (411) est destinée à être appliquée contre une masse susceptible d'entrer en vibration et une deuxième extrémité en appui sur la membrane (11) du capteur (1).

2. Instrument selon la revendication 1, dans lequel la couche de support (111) a une épaisseur comprise entre 5 et 150 µm, de préférence 25 µm.

3. Instrument selon l'une des revendications précédentes, dans lequel la membrane (11) est fixée sur le corps (10) par collage.

4. Instrument selon la revendication 3, dans lequel la membrane (11) est fixée sur le corps (10) par la couche de support (111).

5. Instrument selon l'une des revendications précédentes, **caractérisé en ce qu'**il comporte une tête (4) dans laquelle le capteur (1) est logé, la tige (41) étant reliée par des moyens élastiques (42) à la tête (4).

6. Instrument selon l'une des revendications précédentes, dans lequel la deuxième extrémité de la tige (41) comporte une surface bombée pour être en appui sur la membrane (11).

## Patentansprüche

1. Instrument, **dadurch gekennzeichnet, dass** es einen piezoelektrischen Sensor umfasst, der einen Körper (10) mit einer zentralen Aussparung (12) umfasst, wobei sich über der Aussparung (12) eine Membran (11) erstreckt, die an ihrem Umfang am Körper (10) befestigt ist und eine Trägerschicht (111) aus Polymer und eine empfindliche Schicht (113) aus piezoelektrischem Polymermaterial umfasst, wobei die Membran (11) in der Lage ist, sich zu verformen oder zu schwingen, wobei die empfindliche Schicht (113) aus einem Material besteht, das ein mit anorganischen Aluminiumoxid-Nanomaterialien gefülltes Polymer umfasst, wobei das Polymer der empfindlichen Schicht (113) aus der Gruppe ausgewählt ist, die Polyvinylidenfluorid (PVDF), das Copolymer Vinylidenfluorid-Trifluorethylen P(VDF-TrFE) und Polyamid-11 umfasst, wobei die Trägerschicht (111) aus einem Material besteht, das aus der Gruppe ausgewählt ist, die Polyimid (PI) und Polyetheretherketon (PEEK) umfasst, wobei zwischen der Trägerschicht (111) und der empfindlichen Schicht (113) eine erste leitende Schicht (112) aus Aluminium eingefügt ist, wobei auf einem Teil einer freien Fläche der empfindlichen Schicht (113) eine zweite leitende Schicht (114) abgeschieden ist,
wobei das Instrument weiter eine Übertragungsstange (41) umfasst, von der ein erstes Ende (411) dazu bestimmt ist, an eine Masse angelegt zu werden, die in Schwingung geraten kann, und ein zweites Ende auf der Membran (11) des Sensors (1) aufliegt.

2. Instrument nach Anspruch 1, wobei die Trägerschicht (111) eine Dicke im Bereich zwischen 5 und 150 µm, vorzugsweise 25 µm, aufweist.

3. Instrument nach einem der vorstehenden Ansprüche, wobei die Membran (11) durch Kleben am Körper (10) befestigt ist.

4. Instrument nach Anspruch 3, wobei die Membran (11) über die Trägerschicht (111) am Körper (10) befestigt ist.

5. Instrument nach einem der vorstehenden Ansprüche, **dadurch gekennzeichnet, dass** es einen Kopf (4) umfasst, in dem der Sensor (1) untergebracht ist, wobei die Stange (41) über elastische Mittel (42) mit dem Kopf (4) verbunden ist.

6. Instrument nach einem der vorstehenden Ansprüche, wobei das zweite Ende der Stange (41) eine gewölbte Fläche umfasst, die auf der Membran (11) aufliegen kann.

## Claims

1. Instrument, **characterised in that** it comprises a piezoelectric sensor including a body (10) with a central cavity (12), a membrane (11) extending over the cavity (12), attached to the body (10) via the periphery thereof and including a carrier layer (111) made of polymer and a sensitive layer (113) made of piezoelectric polymer material, the membrane (11) being capable of deforming or vibrating, the sensitive layer (113) being made of a material comprising a polymer filled with inorganic alumina nanomaterials, the polymer of the sensitive layer (113) being selected from the group comprising polyvinylidene fluoride (PVDF), vinylidene fluoride and trifluoroethylene copolymer P(VDF-TrFE) and polyamide-11, the carrier layer (111) being made of a material selected from the group comprising polyimide (PI) and polyether ether ketone (PEEK), a first conductive layer (112) made of aluminium being interposed between the carrier layer (111) and the sensitive layer (113), a second conductive layer (114) being deposited on a portion of a free surface of the sensitive layer (113),
the instrument further including a transmission rod (41), a first end (411) whereof is intended to be applied against a mass that is capable of vibrating and a second end whereof bears against the membrane (11) of the sensor (1).

2. Instrument according to claim 1, wherein the thickness of the carrier layer (111) is comprised between 5 and 150 µm, preferably equal to 25 µm.

3. Instrument according to one of the preceding claims, wherein the membrane (11) is attached to the body (10) by bonding.

4. Instrument according to claim 3, wherein the membrane (11) is attached to the body (10) by the carrier layer (111).

5. Instrument according to one of the preceding claims, **characterised in that** it includes a head (4) wherein the sensor (1) is housed, the rod (41) being linked by elastic means (42) to the head (4).

6. Instrument according to one of the preceding claims, wherein the second end of the rod (41) includes a domed surface for bearing against the membrane (11).
